# EUROPÄISCHE PATENTANMELDUNG

(11) **EP 4 325 176 A1**
(43) Veröffentlichungstag der Anmeldung: **21.02.2024**
(21) Anmeldenummer: 23191469.8
(22) Anmeldetag: 15.08.2023
(51) Int. Cl.: G01D 21/00, G06N 7/02

(54) **MESSGERÄT UND VERFAHREN ZUM BETREIBEN EINES MESSGERÄTS**

(30) Priorität: 15.08.2022 DE 102022120513
(71) Anmelder: Krohne S.A.S., 26103 Romans-sur-Isere Cedex (FR)
(72) Erfinder: DUBRAY, Olivier, 26300 Chatuzange-Le-Goubet (FR); GRAILLAT, Denis, 26540 Mours Saint Eusèbe (FR); LAMBERT, Denis, 26260 Saint Bardoux (FR)
(74) Vertreter: Gesthuysen Patentanwälte

(57) **Zusammenfassung**

Dargestellt und beschrieben ist ein Verfahren zum Betreiben eines Messgeräts (1), welches eine Versorgungsvorrichtung (2) mit einem Pufferspeicher (3) und als Verbraucher eine Stromschleifenschnittstelle (4), eine Steuerung (5) und eine Messvorrichtung (6) aufweist. Die Stromschleifenschnittstelle (4) ist mit einer Stromschleife (7) verbunden und zur Kommunikation über die Stromschleife (7) ausgebildet ist. Die Versorgungsvorrichtung (2) wird mit Energie aus der Stromschleife (7) versorgt und von der Versorgungseinrichtung (2) werden unter Verwendung des Pufferspeichers (3) die Verbraucher mit Energie versorgt.

Die Erfindung löst die Aufgabe, ein Verfahren anzugeben, bei welchem weitere vom Messgerät (1) ausführbare Verfahrensschritte bestimmt werden, welche nicht mehr als eine zur Verfügung stehende Energie für eine Dauer der Ausführung benötigen.

Die Aufgabe ist dadurch gelöst, dass in der Steuerung (5) eine Spannungs-Zugehörigkeitsfunktion abgespeichert wird, welche einer Pufferspannung (u) des Pufferspeichers (3) einen Spannungs-Zugehörigkeitsgrad (Zᵤ) zu einer Spannungs-Fuzzy-Menge von ausreichenden Pufferspannungen zuweist. Dass in der Steuerung (5) mindestens eine Betriebsparameter-Zugehörigkeitsfunktion abgespeichert wird, welche einem Betriebsparameterwert (i, Δt, u/t, i/t) des Messgeräts (1) einen Betriebsparameter-Zugehörigkeitsgrad (Zᵢ, Zₜ, Zᵤₛ, Zᵢₛ) zu einer Betriebsparameter-Fuzzy-Menge ausreichender Betriebsparameterwerte zuweist. Dass von der Steuerung (5) mindestens ein Betriebsparameterwert bestimmt und in einem ersten Zeitpunkt (t₁) eine erste Pufferspannung (u₁) gemessen werden. Dass von der Steuerung (5) ein Fuzzy-Algorithmus mit den folgenden Verfahrensschritten ausgeführt wird:
- Bestimmen des Spannungs-Zugehörigkeitsgrads (Zᵤ) der ersten Pufferspannung (u₁) unter Verwendung der Spannungs-Zugehörigkeitsfunktion,
- Bestimmen des mindestens einen Betriebsparameter-Zugehörigkeitsgrads (Zᵢ, Zₜ, Zᵤₛ, Zᵢₛ) des mindestens einen Betriebsparameterwerts (i, Δt, u/t, i/t) unter Verwendung der mindestens einen Betriebsparameter-Zugehörigkeitsfunktion und
- Bestimmen eines Ergebnis-Zugehörigkeitsgrads (Zₑ) durch Verknüpfung des Spannungs-Zugehörigkeitsgrads (Zᵤ) und des Betriebsparameter-Zugehörigkeitsgrads (Zᵢ, Zₜ, Zᵤₛ, Zᵢₛ) miteinander.

Weiter wird von der Steuerung (5) unter Verwendung des Ergebnis-Zugehörigkeitsgrads (Zₑ) ein weiterer vom Messgerät (1) ausführbarer Verfahrensschritt bestimmt, welcher nicht mehr als eine zur Verfügung stehende Energie für eine Dauer einer Ausführung des Verfahrensschritts benötigt.

## Beschreibung

Die Erfindung betrifft zum einen ein Verfahren zum Betreiben eines Messgeräts. Das Messgerät weist zum einen eine Versorgungsvorrichtung mit einem Pufferspeicher und zum anderen als Verbraucher eine Stromschleifenschnittstelle, eine Messvorrichtung und eine Steuerung auf. Die Stromschleifenschnittstelle ist mit einer Stromschleife verbunden und zur Kommunikation über die Stromschleife ausgebildet. Die Versorgungsvorrichtung wird mit Energie aus der Stromschleife versorgt und von der Versorgungseinrichtung werden unter Verwendung des Pufferspeichers die Verbraucher mit Energie versorgt.

Die Erfindung betrifft zum anderen ein Messgerät mit zum einen einer Versorgungsvorrichtung mit einem Pufferspeicher und zum anderen als Verbraucher einer Stromschleifenschnittstelle, einer Messvorrichtung und einer Steuerung. Die Stromschleifenschnittstelle ist zur Verbindung mit einer Stromschleife und zur Kommunikation über die Stromschleife ausgebildet. Die Versorgungsvorrichtung ist zur Versorgung aus der Stromschleife mit Energie und zur Versorgung der Verbraucher mit Energie unter Verwendung des Pufferspeichers ausgebildet.

Die Versorgungsvorrichtung weist also den Pufferspeicher auf und ist zur Versorgung der Verbraucher mit Energie unter Verwendung des Pufferspeichers ausgebildet. Die Verbraucher sind insbesondere die Stromschleifenschnittstelle, die Messvorrichtung und die Steuerung. Im Betrieb des Messgeräts versorgt die Versorgungsvorrichtung die Verbraucher mit Energie, welche die Versorgungsvorrichtung aus der Stromschleife entnimmt. Der Pufferspeicher ist zum Zwischenspeichern von Energie ausgebildet. Hier ist mit Energie immer elektrische Energie gemeint.

Der Stromschleife ist eine für gewöhnlich über der Zeit variable Leistung entnehmbar. Wenn in einem Zeitpunkt die der Stromschleife entnehmbare Leistung geringer als die vom Messgerät benötigte Leistung ist, dann erfolgt die Versorgung der Verbraucher mit Energie zumindest teilweise aus dem Pufferspeicher, solange im Pufferspeicher ausreichend Energie vorhanden ist. Wenn in einem Zeitpunkt die der Stromschleife entnehmbare Leistung größer als die vom Messgerät benötigte Leistung ist, dann wird der Pufferspeicher aufgeladen.

Die vom Messgerät benötigte Leistung hängt wesentlich von einem vom Messgerät ausgeführten Verfahrensschritt ab. Ein Verfahrensschritt ist zum Beispiel eine von der Messvorrichtung ausgeführte Messung oder eine von der Stromschleifenschnittstelle ausgeführte Kommunikation. Verfahrensschritte werden von der Steuerung gesteuert. Ein Verfahrensschritt benötigt zur Durchführung eine bestimmte Menge Energie und über eine Dauer der Ausführung eine entsprechende Leistung.

Ein Ausführen eines Verfahrensschritts durch das Messgerät, welcher mehr Energie benötigt als der Stromschleife und dem Pufferspeicher während einer Dauer der Ausführung entnehmbar sind, bedeutet eine Unterversorgung des Messgeräts mit Energie, wodurch eine Betriebssicherheit des Messgeräts nicht gewährleistet ist.

Aufgabe der vorliegenden Erfindung ist daher die Angabe eines Messgeräts und eines Verfahrens zum Betreiben eines Messgeräts, bei welchem weitere vom Messgerät ausführbare Verfahrensschritte bestimmt werden, welche nicht mehr als eine zur Verfügung stehende Energie für eine Dauer der Ausführung benötigen.

Die Aufgabe wird zum einen durch ein Verfahren zum Betreiben eines Messgeräts mit den Merkmalen von Anspruch 1 gelöst. Gemäß dem Verfahren wird in der Steuerung eine Spannungs-Zugehörigkeitsfunktion abgespeichert, welche einer Pufferspannung des Pufferspeichers einen Spannungs-Zugehörigkeitsgrad zu einer Spannungs-Fuzzy-Menge von ausreichenden Pufferspannungen zuweist. Weiter wird in der Steuerung mindestens eine weitere Betriebsparameter-Zugehörigkeitsfunktion abgespeichert, welche einem Betriebsparameterwert des Messgeräts einen Betriebsparameter-Zugehörigkeitsgrad zu einer Betriebsparameter-Fuzzy-Menge ausreichender Betriebsparameterwerte zuweist.

Weiter wird von der Steuerung mindestens ein Betriebsparameterwert bestimmt und in einem ersten Zeitpunkt eine erste Pufferspannung gemessen.

Dann wird von der Steuerung ein Fuzzy-Algorithmus mit den folgenden Verfahrensschritten ausgeführt:
In einem ersten Verfahrensschritt wird der Spannungs-Zugehörigkeitsgrad der ersten Pufferspannung unter Verwendung der Spannungs-Zugehörigkeitsfunktion bestimmt.

In einem zweiten Verfahrensschritt wird der mindestens eine Betriebsparameter-Zugehörigkeitsgrad des mindestens einen Betriebsparameterwerts unter Verwendung der mindestens einen Betriebsparameter-Zugehörigkeitsfunktion bestimmt.

In einem dritten Verfahrensschritt wird ein Ergebnis-Zugehörigkeitsgrad durch Verknüpfung des Spannungs-Zugehörigkeitsgrads und des mindestens einen Betriebsparameter-Zugehörigkeitsgrads miteinander bestimmt.

Dann wird von der Steuerung unter Verwendung des Ergebnis-Zugehörigkeitsgrads ein weiterer vom Messgerät ausführbarer Verfahrensschritt bestimmt, welcher nicht mehr als eine zur Verfügung stehende Energie für eine Dauer einer Ausführung des Verfahrensschritts benötigt.

Die Spannungs-Zugehörigkeitsfunktion, die mindestens eine weitere Betriebsparameter-Zugehörigkeitsfunktion und die Verknüpfung sind derart bestimmt, sodass sie ein Maß für die zur Verfügung stehende Energie sind. Weiter sind in der Steuerung Informationen über einen Energiebedarf weiterer Verfahrensschritte abgespeichert.

Das erfindungsgemäße Verfahren hat den Vorteil, dass ein vom Messgerät ausführbarer Verfahrensschritt dynamisch bestimmt wird, welcher nicht mehr als eine zur Verfügung stehende Energie für eine Dauer einer Ausführung benötigt. Dadurch ist die Betriebssicherheit des Messgeräts verbessert.

In der Steuerung ist mindestens eine Betriebsparameter-Zugehörigkeitsfunktion abgespeichert und diese mindestens eine Betriebsparameter-Zugehörigkeitsfunktion wird von der Steuerung verwendet. Im Folgenden werden mehrere dieser Betriebsparameter-Zugehörigkeitsfunktionen und deren Verwendung im Rahmen des Verfahrens beschrieben.

In einer Ausgestaltung des Verfahrens ist die mindestens eine weitere Betriebsparameter-Zugehörigkeitsfunktion einer Strom-Zugehörigkeitsfunktion. Diese weist einem Schleifenstrom der Stromschleife einen Strom-Zugehörigkeitsgrad zu einer Strom-Fuzzy-Menge von ausreichenden Schleifenströmen zu. Von der Steuerung wird im ersten Zeitpunkt ein Schleifenstrom als der Betriebsparameterwert bestimmt.

In einer weiteren Ausgestaltung ist die mindestens eine weitere Betriebsparameter-Zugehörigkeitsfunktion eine Zeitabstands-Zugehörigkeitsfunktion. Diese weist einem Zeitabstand einen Zeitabstands-Zugehörigkeitsgrad zu einer Zeitabstands-Fuzzy-Menge von ausreichenden Zeitabständen zu. Von dem Messgerät wird bis zu einem vor dem ersten Zeitpunkt liegenden Ausführungszeitpunkt ein Verfahrensschritt ausgeführt. Bei diesem Verfahrensschritt wird zum Beispiel von der Stromschleifenschnittstelle eine Kommunikation oder von der Messvorrichtung eine Messung ausgeführt. Weiter wird von der Steuerung ein Zeitabstand zwischen dem ersten Zeitpunkt und dem Ausführungszeitpunkt als Betriebsparameterwert bestimmt. Eine Alternative unterscheidet sich dahingehend, dass von dem Messgerät ab einem vor dem ersten Zeitpunkt liegenden Ausführungszeitpunkt ein Verfahrensschritt ausgeführt wird. In diesem Fall ist die Ausführung des Verfahrensschritts vorzugsweise vor dem ersten Zeitpunkt abgeschlossen.

In einer weiteren Ausgestaltung ist die mindestens eine weitere Betriebsparameter-Zugehörigkeitsfunktion eine Spannungssteigung-Zugehörigkeitsfunktion. Diese weist einer Spannungssteigung einen Spannungssteigungs-Zugehörigkeitsgrad zu einer Spannungssteigungs-Fuzzy-Menge von ausreichenden Spannungssteigungen zu. Weiter wird von der Steuerung eine zweite Pufferspannung in einem zweiten Zeitpunkt gemessen und wird eine Spannungssteigung zwischen dem ersten Zeitpunkt und dem zweiten Zeitpunkt aus der ersten Pufferspannung und der zweiten Pufferspannung als der Betriebsparameterwert bestimmt. Die Spannungssteigung wird aus einer Spannungsdifferenz zwischen der ersten und der zweiten Pufferspannung und aus einer Zeitdifferenz zwischen dem ersten und dem zweiten Zeitpunkt bestimmt. Der zweite Zeitpunkt und der Ausführungszeitpunkt können zusammenfallen. Für gewöhnlich liegt der zweite Zeitpunkt zeitlich vor dem ersten Zeitpunkt.

In einer weiteren Ausgestaltung ist die mindestens eine weitere Betriebsparameter-Zugehörigkeitsfunktion eine Stromsteigungs-Zugehörigkeitsfunktion. Diese weist einer Stromsteigung einen Stromsteigungs-Zugehörigkeitsgrad zu einer Stromsteigungs-Fuzzy-Menge von ausreichenden Stromsteigungen zu. Weiter wird von der Steuerung ein erster Schleifenstrom im ersten Zeitpunkt und ein zweiter Schleifenstrom in einem zweiten Zeitpunkt bestimmt und wird eine Stromsteigung zwischen dem ersten Zeitpunkt und dem zweiten Zeitpunkt aus dem ersten Schleifenstrom und dem zweiten Schleifenstrom als der Betriebsparameterwert bestimmt. Die Stromsteigung wird aus einer Stromdifferenz zwischen dem ersten und dem zweiten Schleifenstrom und aus einer Zeitdifferenz zwischen dem ersten und dem zweiten Zeitpunkt bestimmt.

Ein Schleifenstrom, insbesondere der erste und der zweite Schleifenstrom, wird bestimmt, indem er gemessen oder indem ein Sollstrom ausgelesen wird. Das Messen oder das Auslesen wird zum Beispiel von der Steuerung ausgeführt. Der Sollstrom wird zum Beispiel von der Steuerung der Stromschleifenschnittstelle vorgegeben und ist in der Steuerung abgespeichert, sodass er auslesbar ist.

In einer weiteren Ausgestaltung umfasst die Verknüpfung des Spannungs-Zugehörigkeitsgrads und des mindestens eines Betriebsparameter-Zugehörigkeitsgrads zumindest eine Multiplikation.

Zugehörigkeitsfunktionen wie die zuvor genannten weisen einem Parameterwert einen Zugehörigkeitsgrad zu einer Fuzzy-Menge von ausreichenden Parameterwerten zu. Ein Zugehörigkeitsgrad hat grundsätzlich einen Wert zwischen 0 und 1. Parameterwerte sind die Pufferspannung und die aufgeführten Betriebsparameterwerte. Ein Betriebsparameter ist ein Parameter des Messgeräts, welcher einen Betriebszustand des Messgeräts beschreibt. Folglich sind die Pufferspannung, der Schleifenstrom, der Zeitabstand, die Spannungssteigung und die Stromsteigung Betriebsparameter.

In einer Gruppe von Verfahren werden immer zwei Betriebsparameterwerte bestimmt, wobei einer der beiden Betriebsparameterwerte immer die Pufferspannung ist. Der andere Betriebsparameterwert ist entweder der Schleifenstrom oder der Zeitabstand oder die Spannungssteigung oder die Stromsteigung.

In einer bevorzugten Ausgestaltung dieser Gruppe von Verfahren wird in der Steuerung die Spannungssteigungs-Zugehörigkeitsfunktion als die mindestens eine Betriebsparameter-Zugehörigkeitsfunktion abgespeichert. Sie weist der Spannungssteigung den Spannungssteigungs-Zugehörigkeitsgrad zu der Spannungssteigungs-Fuzzy-Menge zu. Dabei ist die Spannungssteigung der Betriebsparameterwert, der Spannungssteigungs-Zugehörigkeitsgrad der Betriebsparameter-Zugehörigkeitsgrad und die Spannungssteigungs-Fuzzy-Menge die Betriebsparameter-Fuzzy-Menge.

Von der Steuerung werden dementsprechend die Spannungssteigung und der Spannungssteigungs-Zugehörigkeitsgrad unter Verwendung der Spannungssteigungs-Zugehörigkeitsfunktion bestimmt und wird dann der Ergebnis-Zugehörigkeitsgrad durch Verknüpfung des Spannungs-Zugehörigkeitsgrads und des Spannungssteigungs-Zugehörigkeitsgrads bestimmt.

Zur Erhöhung einer Genauigkeit der Bestimmung der ausführbaren Verfahrensschritte, welche nicht mehr als eine zur Verfügung stehende Energie für eine Dauer einer Ausführung benötigen, werden in einer weiteren Gruppe von Verfahren mehr als zwei Betriebsparameterwerte bestimmt und deren Zugehörigkeitsgrade miteinander verknüpft.

In einer bevorzugten Ausgestaltung dieser Verfahren wird von der Steuerung zum einen die Strom-Zugehörigkeitsfunktion und zum anderen die Stromsteigungs-Zugehörigkeitsfunktion als die Betriebsparameter-Zugehörigkeitsfunktionen abgespeichert.

Von der Steuerung werden dementsprechend der Schleifenstrom und die Stromsteigung bestimmt, dann der Strom-Zugehörigkeitsgrad und der Stromsteigungs-Zugehörigkeitsgrad bestimmt und weiter der Ergebnis-Zugehörigkeitsgrad durch Verknüpfung des Spannungs-Zugehörigkeitsgrads, des Strom-Zugehörigkeitsgrads und des Stromsteigungs-Zugehörigkeitsgrads miteinander bestimmt.

Bei allen Verfahren wird von der Steuerung unter Verwendung des Ergebnis-Zugehörigkeitsgrads ein weiterer vom Messgerät ausführbarer Verfahrensschritt bestimmt. Dazu ist in einer weiteren Ausgestaltung vorgesehen, dass von der Steuerung, wenn der Ergebnis-Zugehörigkeitsgrad größer als ein erster Grenzwert ist, der weitere Verfahrensschritt eine von der Messvorrichtung ausführbare Messung oder Diagnose oder ausführbarer Verbrauchsalgorithmus ist und dass, wenn der Ergebnis-Zugehörigkeitsgrad kleiner als der erste Grenzwert und größer als ein zweiter Grenzwert ist, der weitere Verfahrensschritt eine von der Stromschleifenschnittstelle ausführbare Kommunikation ist.

Der Ergebnis-Zugehörigkeitsgrad hat für gewöhnlich einen Wert zwischen 0 und 1. Der Wert korrespondiert dabei mit der zur Verfügung stehenden Energie, wobei ein höherer Wert für eine größere zur Verfügung stehende Energie steht als ein kleinerer Wert. Da eine von der Messvorrichtung ausführbare Messung für gewöhnlich mehr Energie benötigt als eine von der Stromschleifenschnittstelle ausführbare Kommunikation über die Stromschleifenschnittstelle, sind der erste Grenzwert und der zweite Grenzwert entsprechend bemessen und in der Steuerung abgespeichert.

In einer weiteren Ausgestaltung ist, wenn der Ergebnis-Zugehörigkeitsgrad 0 ist, der weitere Verfahrensschritt ein Null-Schritt. Der Null-Schritt bedeutet, dass von dem Messgerät und insbesondere von der Steuerung kein weiterer Verfahrensschritt ausgeführt wird, da für einen solchen keine ausreichende Energie zur Verfügung steht.

Die Aufgabe wird zum anderen auch durch ein Messgerät mit den Merkmalen von Anspruch 11 gelöst. Das Messgerät ist dadurch gekennzeichnet, dass in der Steuerung eine Spannungs-Zugehörigkeitsfunktion und mindestens eine Betriebsparameter-Zugehörigkeitsfunktion abgespeichert sind. Die Spannungs-Zugehörigkeitsfunktion weist einer Pufferspannung des Pufferspeichers einen Spannungs-Zugehörigkeitsgrad zu einer Spannungs-Fuzzy-Menge von ausreichenden Pufferspannungen zu. Die Betriebsparameter-Zugehörigkeitsfunktion weist einem Betriebsparameterwert des Messgeräts einen Betriebsparameter-Zugehörigkeitsgrad zu einer Betriebsparameter-Fuzzy-Menge ausreichender Betriebsparameterwerte zu.

Weiter ist die Steuerung ausgebildet, mindestens einen Betriebsparameterwert zu bestimmen und in einem ersten Zeitpunkt eine erste Pufferspannung zu messen.

Darüber hinaus ist die Steuerung zum Ausführen eines Fuzzy-Algorithmus mit den folgenden Verfahrensschritten ausgebildet:
In einem ersten Verfahrensschritt wird der Spannungs-Zugehörigkeitsgrad der ersten Pufferspannung unter Verwendung der Spannungs-Zugehörigkeitsfunktion bestimmt.

In einem zweiten Verfahrensschritt wird der mindestens eine Betriebsparameter-Zugehörigkeitsgrad des mindestens eines Betriebsparameterwerts unter Verwendung der mindestens eine Betriebsparameter-Zugehörigkeitsfunktion bestimmt.

In einem dritten Verfahrensschritt wird ein Ergebnis-Zugehörigkeitsgrad durch Verknüpfung des Spannungs-Zugehörigkeitsgrads und des mindestens eines Betriebsparameter-Zugehörigkeitsgrads miteinander bestimmt.

Weiter ist die Steuerung ausgebildet, unter Verwendung des Ergebnis-Zugehörigkeitsgrads einen weiteren vom Messgerät ausführbaren Verfahrensschritt zu bestimmen, welcher nicht mehr als eine zur Verfügung stehende Energie für eine Dauer einer Ausführung des Verfahrensschritts benötigt.

In einer Ausgestaltung des Messgeräts ist das Messgerät, insbesondere die Steuerung, ausgebildet, eines des zuvor beschriebenen Verfahren auszuführen.

In einer Ausgestaltung ist die Stromschleifenschnittstelle zur Kommunikation gemäß einem 4 mA bis 20 mA-Standard über die Stromschleife ausgebildet. Bei diesem Standard wird eine Information durch einen Betrag des Schleifenstroms in der Stromschleife dargestellt. Eine Information ist zum Beispiel ein von der Messvorrichtung gemessener Messwert. Das bedeutet jedoch auch, dass die der Stromschleife entnehmbare Leistung von der über die Stromschleife übertragenen Information abhängig ist. Das beschriebene Verfahren und das beschriebene Messgerät eigenen sich deshalb insbesondere für eine Kombination mit diesem Standard. Dann ist auch die Verwendung des Strom-Zugehörigkeitsgrads bei der Bestimmung des Ergebnis-Zugehörigkeitsgrads besonders vorteilhaft.

In einer weiteren Ausgestaltung des Messgeräts ist die Stromschleifenschnittstelle zur Kommunikation gemäß einem digitalen Busprotokoll über die Stromschleife und/oder einem Bluetooth-Standard über einen zusätzlichen Transceiver in der Stromschleifenschnittstelle ausgebildet. Bei diesem Busprotokoll handelt sich zum Beispiel um einen HART-Standard. Wenn die Stromschleifenschnittstelle zur Kommunikation gemäß einem Bluetooth-Standard über einen zusätzlichen Transceiver ausgebildet ist, dann ist der Transceiver entweder ein Teil der Stromschleifenschnittstelle oder separat von dieser.

In einer weiteren Ausgestaltung ist der Pufferspeicher ein Kondensator.

In einer weiteren Ausgestaltung ist das Messgerät ein Füllstandsmessgerät, vorzugsweise ein Radar-Füllstandsmessgerät.

Im Übrigen gelten die Ausführungen zum Verfahren für das Messgerät entsprechend und umgekehrt.

Im Einzelnen ist eine Vielzahl an Möglichkeiten gegeben, das Verfahren zum Betreiben eines Messgeräts und das Messgerät auszugestalten und weiterzubilden. Dazu wird verwiesen zum einen auf die den unabhängigen Ansprüchen nachgeordneten Ansprüche und zum anderen auf die nachfolgende Beschreibung eines bevorzugten Ausführungsbeispiels in Verbindung mit der Zeichnung. In der Zeichnung zeigt:
- Fig. 1: Ein Ausführungsbeispiel eines Messgeräts,
- Fig. 2a: ein Ausführungsbeispiel einer Spannungs-Zugehörigkeitsfunktion,
- Fig. 2b: ein Ausführungsbeispiel einer Strom-Zugehörigkeitsfunktion,
- Fig. 2c: ein Ausführungsbeispiel einer Zeitabstands-Zugehörigkeitsfunktion,
- Fig. 2d: ein Ausführungsbeispiel einer Spannungssteigungs-Zugehörigkeitsfunktion,
- Fig. 2e: ein Ausführungsbeispiel einer Stromsteigungs-Zugehörigkeitsfunktion und
- Fig. 3: einen Ablaufplan eines Ausführungsbeispiels eines Verfahrens zum Betreiben des Messgeräts.

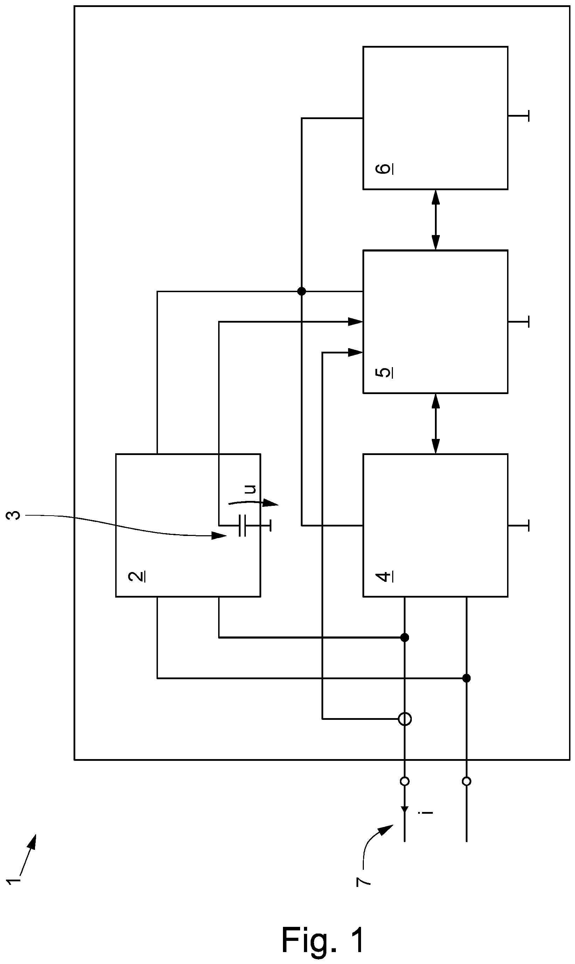

Fig. 1 zeigt wesentliche Elemente eines Ausführungsbeispiels eines Messgeräts 1 in einer abstrahierten Darstellung. Das Messgerät 1 weist als wesentliche Elemente eine Versorgungsvorrichtung 2 mit einem Pufferspeicher 3 und als Verbraucher eine Stromschleifenschnittstelle 4, eine Steuerung 5 und eine Messvorrichtung 6 auf. Der Pufferspeicher 3 ist ein Kondensator. Das Messgerät 1 ist in diesem Ausführungsbeispiel ein Radar-Füllstandsmessgerät. Dementsprechend ist die Messvorrichtung 6 zur Bestimmung eines Füllstands eines Mediums mittels Radar ausgebildet.

Die Stromschleifenschnittstelle 4 ist zur Verbindung mit einer Stromschleife 7 und zur Kommunikation über die Stromschleife 7 ausgebildet. Im vorliegenden Ausführungsbeispiel ist die Stromschleifenschnittstelle 4 mit der Stromschleife 7 verbunden und zur Kommunikation gemäß einem 4 mA bis 20 mA-Standard über die Stromschleife 7 ausgebildet. Im Betrieb des Messgeräts 1 werden zum Beispiel von der Messvorrichtung 6 bestimmte Messwerte gemäß diesem Standard übertragen.

Die Versorgungsvorrichtung 2 ist zur Versorgung mit Energie aus der Stromschleife 7 und zur Versorgung der Verbraucher, also insbesondere der Stromschleifenschnittstelle 4, der Steuerung 5 und der Messvorrichtung 6, mit Energie unter Verwendung des Pufferspeichers 3 ausgebildet. Zur Versorgung der Versorgungsvorrichtung 2 mit Energie aus der Stromschleife 7 ist die Versorgungsvorrichtung 2 mit der Stromschleife 7 verbunden. Zur Versorgung der Verbraucher mit Energie durch die Versorgungseinrichtung 2 ist die Versorgungsvorrichtung 2 jeweils mit der Stromschleifenschnittstelle 4, der Steuerung 5 und der Messvorrichtung 6 verbunden.

Das Messgerät 1 ist im Betrieb, weshalb die Versorgungsvorrichtung 2 mit Energie aus der Stromschleife 7 versorgt wird und von der Versorgungseinrichtung 2 unter Verwendung des Pufferspeichers 3 die Verbraucher mit Energie versorgt werden.

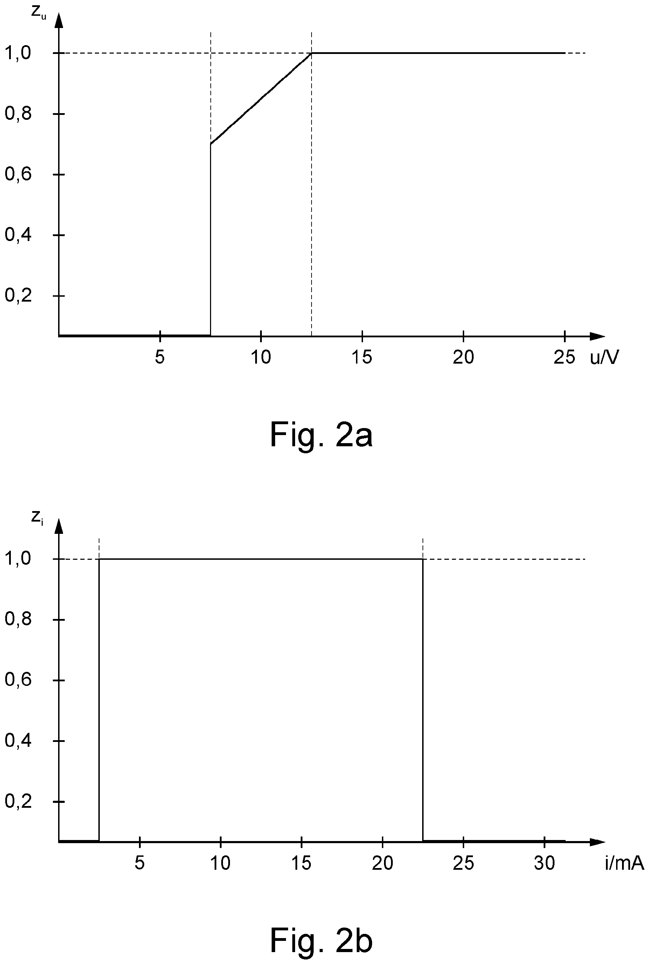

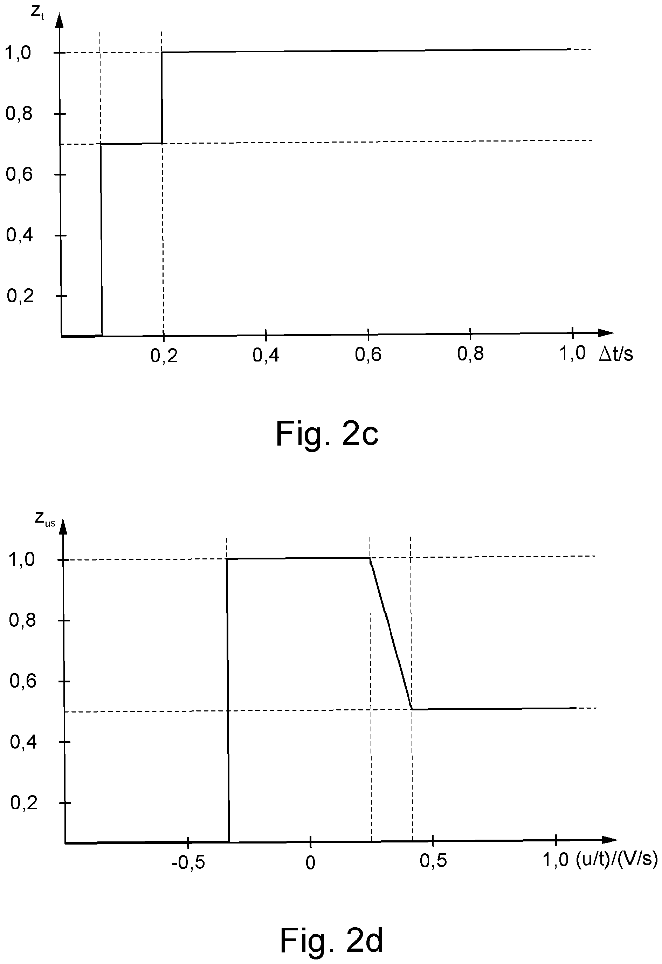

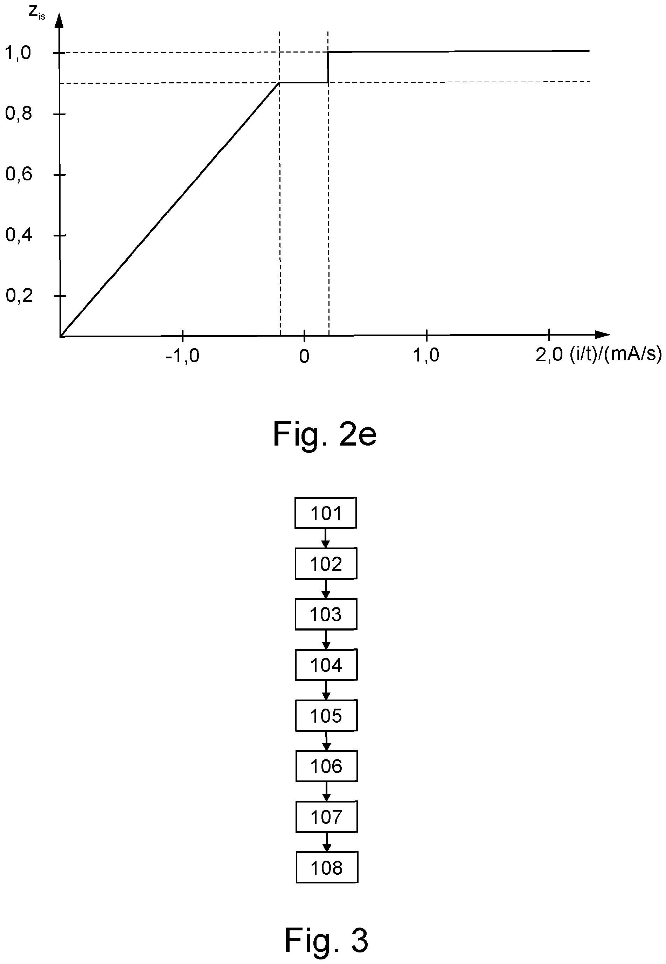

In der Steuerung 5 sind eine Spannungs-Zugehörigkeitsfunktion, siehe Fig. 2a, eine Strom-Zugehörigkeitsfunktion, siehe Fig. 2b, eine Zeitabstands-Zugehörigkeitsfunktion, siehe Fig. 2c, und eine Spannungssteigungs-Zugehörigkeitsfunktion, siehe Fig. 2d, als Betriebsparameter-Zugehörigkeitsfunktionen abgespeichert. Alternativ zu einer der vorgenannten oder zusätzlich zu den vorgenannten Betriebsparameter-Zugehörigkeitsfunktionen kann in der Steuerung 5 auch eine Stromsteigungs-Zugehörigkeitsfunktion, siehe Fig. 2e, abgespeichert sein. Im Einzelnen gilt für die aufgeführten Betriebsparameter-Zugehörigkeitsfunktionen:
Die Spannungs-Zugehörigkeitsfunktion weist einer Pufferspannung u des Pufferspeichers 3 einen Spannungs-Zugehörigkeitsgrad Zᵤ zu einer Spannungs-Fuzzy-Menge von ausreichenden Pufferspannungen zu. Zᵤ ist 0 für Pufferspannung u kleiner als 7,5 V und 1 für Pufferspannungen u größer als 12,5 V Zᵤ steigt für Pufferspannungen u im Bereich zwischen 7,5 V und 12,5 V linear von 0,7 auf 1 an.

Die Strom-Zugehörigkeitsfunktion weist einem Schleifenstrom i der Stromschleife 7 einen Strom-Zugehörigkeitsgrad Zᵢ zu einer Strom-Fuzzy-Menge von ausreichenden Schleifenströmen zu. Zᵢ ist 0 für Schleifenströme i kleiner als 2,5 mA und größer als 22,5 mA. Zᵢ ist 1 für Schleifenströme i im Bereich zwischen 2,5 mA und 22,5 mA.

Die Zeitabstands-Zugehörigkeitsfunktion weist einem Zeitabstand Δt einen Zeitabstands-Zugehörigkeitsgrad Zₜ zu einer Zeitabstands-Fuzzy-Menge von ausreichenden Zeitabständen zu. Zₜ ist 0 für Zeitabstände Δt kleiner als 0,08 s, ist 0,7 für Zeitabstände Δt im Bereich zwischen 0,08 s und 0,2 s und ist 1 für Zeitabstände Δt größer als 0,2 s.

Die Spannungssteigungs-Zugehörigkeitsfunktion weist einer Spannungssteigung u/t, einen Spannungssteigungs-Zugehörigkeitsgrad Zᵤₛ zu einer Spannungssteigungs-Fuzzy-Menge von ausreichenden Spannungssteigungen zu. Zᵤₛ ist 0 für Spannungssteigungen u/t kleiner als -0,4 V/s und ist 1 für Spannungssteigungen u/t im Bereich zwischen -0,4 V/s und 0,25 V/s. Zᵤₛ ist 0,5 für Spannungssteigungen u/t größer als 0,4 V/s und sinkt für Spannungssteigungen u/t im Bereich größer als 0,25 V/s und kleiner oder gleich 0,4 V/s linear von 1 auf 0,5 ab. Folglich hat ein Laden und ein Entladen mit einem Betrag der Spannungssteigung von 0,4 V/s keinen negativen Effekt.

Die Stromsteigungs-Zugehörigkeitsfunktion weist einer Stromsteigung i/t einen Stromsteigungs-Zugehörigkeitsgrad Zᵢₛ zu einer Stromsteigungs-Fuzzy-Menge von ausreichenden Stromsteigungen zu. Zᵢₛ ist 0 für Stromsteigungen i/t kleiner als -2 mA/s und ist 1 für Stromsteigungen i/t größer als 0,2 mA/s. Zᵢₛ steigt für Stromsteigungen i/t im Bereich von -2 mA/s bis -0,2 mA/s linear von 0 auf 0,9 an und ist im Bereich größer als 0,2 mA/s und kleiner oder gleich 0,2 mA/s konstant.

Die Verläufe der Zugehörigkeitsfunktionen in den Figuren 2a bis 2e sind typische Verläufe, die sich in der Praxis bewährt haben. Die Verläufe gelten qualitativ, also unabhängig von den angegebenen Werten.

Die Steuerung 5 ist zur Bestimmung der Betriebsparameterwerte der verwendeten Betriebsparameter-Zugehörigkeitsfunktionen ausgebildet. Insbesondere ist sie zur Messung des Schleifenstroms i und der Pufferspannung u ausgebildet, was in Fig. 1 durch die beiden auf die Steuerung 5 weisenden Pfeile angedeutet ist. Weiter ist die Steuerung 5 zur Kommunikation zum einen mit der Stromschleifenschnittstelle 4 und zum anderen mit der Messvorrichtung 6 ausgebildet, was in Fig. 1 durch die Doppelpfeile angedeutet ist. Insbesondere ist die Steuerung 5 zur Kommunikation über die Stromschleifenschnittstelle 4 und zur Steuerung der Messvorrichtung 6 ausgebildet.

Die Steuerung 5 ist ausgebildet, die folgenden Verfahrensschritte, siehe Fig. 3, auszuführen und führt diese auch aus, da das Messgerät 1 im Betrieb ist:
In einem ersten Verfahrensschritt 101 werden in einem ersten Zeitpunkt t₁ = 1 s eine erste Pufferspannung u₁ = 15 V und ein Schleifenstrom i = 10 mA gemessen.

In einem zweiten Verfahrensschritt 102 wird in einem zweiten Zeitpunkt t₂ = 0,85 s eine zweite Pufferspannung u₂ = 14,925 V gemessen. Vorliegend liegt t₂ zeitlich vor t₁ und wird auch als Ausführungszeitpunkt bezeichnet.

In einem dritten Verfahrensschritt 103 wird der Spannungs-Zugehörigkeitsgrad Zᵤ = 1 der ersten Pufferspannung u₁ = 15 V unter Verwendung der Spannungs-Zugehörigkeitsfunktion bestimmt.

In einem vierten Verfahrensschritt 104 wird der Strom-Zugehörigkeitsgrad Zᵢ = 1 des Schleifenstroms i = 10 mA unter Verwendung der Strom-Zugehörigkeitsfunktion bestimmt.

In einem fünften Verfahrensschritt 105 wird ein Zeitabstand Δt = 0,15 s zwischen dem ersten Zeitpunkt t₁ = 1 s und dem zweiten Zeitpunkt t₂ = 0,85 s bestimmt und wird der Zeitabstands-Zugehörigkeitsgrad Zₜ = 0,7 des Zeitabstands Δt unter Verwendung der Zeitabstands-Zugehörigkeitsfunktion bestimmt.

In einem sechsten Verfahrensschritt 106 wird eine Differenzspannung Δu = 0,075 V zwischen der ersten Pufferspannung u₁ = 15 V und der zweiten Pufferspannung u₂ = 14,925 V bestimmt und wird eine Spannungssteigung u/s = 0,5 V/s bestimmt, indem ein Quotient aus der Differenzspannung Δu und dem Zeitabstand Δt gebildet wird. Weiter wird der Spannungssteigungs-Zugehörigkeitsgrad Zᵤₛ = 0,5 der Spannungssteigerung u/s unter Verwendung der Spannungssteigungs-Zugehörigkeitsfunktion bestimmt.

In einem siebten Verfahrensschritt 107 wird ein Ergebnis-Zugehörigkeitsgrad Zₑ durch Verknüpfung des Spannungs-Zugehörigkeitsgrads, des Strom-Zugehörigkeitsgrads, des Zeitabstands-Zugehörigkeitsgrads und des Spannungssteigungs-Zugehörigkeitsgrads miteinander bestimmt. Die Verknüpfung erfolgt durch Multiplikation der einzelnen Zugehörigkeitsgrade. Also gilt: Zₑ = Zᵤ · Zᵢ · Zₜ · Zᵤₛ= 1 · 1 · 0,7 · 0,5 = 0,35

In einem achten Verfahrensschritt 108 wird von der Steuerung 5 unter Verwendung des Ergebnis-Zugehörigkeitsgrads Zₑ ein weiterer vom Messgerät 1 ausführbarer Verfahrensschritt bestimmt, welcher nicht mehr als eine zur Verfügung stehende Energie für eine Dauer einer Ausführung des Verfahrensschritts benötigt. Dafür ist in diesem Ausführungsbeispiel in der Steuerung 5 ein erster Grenzwert von 0,8 und ein zweiter Grenzwert von 0,3 abgespeichert.

Und zwar wird von der Steuerung 5, wenn der Ergebnis-Zugehörigkeitsgrad Zₑ größer als der erste Grenzwert ist, als der weitere Verfahrensschritt eine von der Messvorrichtung 6 ausführbare Messung ausgewählt, und, wenn der Ergebnis-Zugehörigkeitsgrad Zₑ kleiner als der erste Grenzwert und größer als der zweite Grenzwert ist, als der weitere Verfahrensschritt eine von der Stromschleifenschnittstelle 4 ausführbare Kommunikation über die Stromschleifenschnittstelle 4 ausgewählt. Wenn der Ergebnis-Zugehörigkeitsgrad Zₑ = 0 ist, dann wird als der weitere Verfahrensschritt ein Nullschritt ausgeführt.

Vorliegend ist der Ergebnis-Zugehörigkeitswert Zₑ = 0,35 und damit kleiner als der erste Grenzwert und größer als der zweite Grenzwert, weshalb der weitere Verfahrensschritt eine ausführbare Kommunikation ist. Diese benötigt für die Ausführung weniger Energie als zur Verfügung steht, wodurch die Betriebssicherheit gewährleistet ist.

### Bezugszeichen

- 1: Messgerät
- 2: Versorgungsvorrichtung
- 3: Pufferspeicher
- 4: Stromschleifenschnittstelle
- 5: Steuerung
- 6: Messvorrichtung
- 7: Stromschleife
- 101: erster Verfahrensschritt
- 102: zweiter Verfahrensschritt
- 103: dritter Verfahrensschritt
- 104: vierter Verfahrensschritt
- 105: fünfter Verfahrensschritt
- 106: sechster Verfahrensschritt
- 107: siebter Verfahrensschritt
- 108: achter Verfahrensschritt
- i: Schleifenstrom
- i/t: Stromsteigung
- u: Pufferspannung
- u/t: Spannungssteigung
- t: Zeit
- Δt: Zeitabstand
- Zₑ: Ergebnis-Zugehörigkeitsgrad
- Zᵤ: Spannungs-Zugehörigkeitsgrad
- Zᵢ: Strom-Zugehörigkeitsgrad
- Zₜ: Zeitabstands-Zugehörigkeitsgrad
- Zᵤₛ: Spannungssteigungs-Zugehörigkeitsgrad
- Zᵢₛ: Stromsteigungs-Zugehörigkeitsgrad

## Patentansprüche

1. Verfahren zum Betreiben eines Messgeräts (1),
wobei das Messgerät (1) eine Versorgungsvorrichtung (2) mit einem Pufferspeicher (3) und als Verbraucher eine Stromschleifenschnittstelle (4), eine Steuerung (5) und eine Messvorrichtung (6) aufweist,
wobei die Stromschleifenschnittstelle (4) mit einer Stromschleife (7) verbunden und zur Kommunikation über die Stromschleife (7) ausgebildet ist,
wobei die Versorgungsvorrichtung (2) mit Energie aus der Stromschleife (7) versorgt wird und von der Versorgungseinrichtung (2) unter Verwendung des Pufferspeichers (3) die Verbraucher mit Energie versorgt werden,
**dadurch gekennzeichnet,**
**dass** in der Steuerung (5) eine Spannungs-Zugehörigkeitsfunktion abgespeichert wird, welche einer Pufferspannung (u) des Pufferspeichers (3) einen Spannungs-Zugehörigkeitsgrad (Zᵤ) zu einer Spannungs-Fuzzy-Menge von ausreichenden Pufferspannungen zuweist,
**dass** in der Steuerung (5) mindestens eine Betriebsparameter-Zugehörigkeitsfunktion abgespeichert wird, welche einem Betriebsparameterwert (i, Δt, u/t, i/t) des Messgeräts (1) einen Betriebsparameter-Zugehörigkeitsgrad (Zᵢ, Zₜ, Zᵤₛ, Zᵢₛ) zu einer Betriebsparameter-Fuzzy-Menge ausreichender Betriebsparameterwerte zuweist,
**dass** von der Steuerung (5) mindestens ein Betriebsparameterwert bestimmt und in einem ersten Zeitpunkt (t₁) eine erste Pufferspannung (u₁) gemessen werden,
**dass** von der Steuerung (5) ein Fuzzy-Algorithmus mit den folgenden Verfahrensschritten ausgeführt wird:
- Bestimmen des Spannungs-Zugehörigkeitsgrads (Zᵤ) der ersten Pufferspannung (u₁) unter Verwendung der Spannungs-Zugehörigkeitsfunktion,
- Bestimmen des mindestens einen Betriebsparameter-Zugehörigkeitsgrads (Zᵢ, Zₜ, Zᵤₛ, Zᵢₛ) des mindestens einen Betriebsparameterwerts (i, Δt, u/t, i/t) unter Verwendung der mindestens einen Betriebsparameter-Zugehörigkeitsfunktion,
- Bestimmen eines Ergebnis-Zugehörigkeitsgrads (Zₑ) durch Verknüpfung des Spannungs-Zugehörigkeitsgrads (Zᵤ) und des Betriebsparameter-Zugehörigkeitsgrads (Zᵢ, Zₜ, Zᵤₛ, Zᵢₛ) miteinander und
**dass** von der Steuerung (5) unter Verwendung des Ergebnis-Zugehörigkeitsgrads (Zₑ) ein weiterer vom Messgerät (1) ausführbarer Verfahrensschritt bestimmt wird, welcher nicht mehr als eine zur Verfügung stehende Energie für eine Dauer einer Ausführung des Verfahrensschritts benötigt.

2. Verfahren nach Anspruch 1, **dadurch gekennzeichnet,**
**dass** die mindestens eine weitere Betriebsparameter-Zugehörigkeitsfunktion eine Strom-Zugehörigkeitsfunktion ist, welche einem Schleifenstrom (i) der Stromschleife (7) einen Strom-Zugehörigkeitsgrad (Zᵢ) zu einer Strom-Fuzzy-Menge von ausreichenden Schleifenströmen zuweist und
**dass** von der Steuerung (5) im ersten Zeitpunkt (t₁) ein Schleifenstrom (i) als der Betriebsparameterwert bestimmt wird.

3. Verfahren nach Anspruch 2, **dadurch gekennzeichnet, dass** der Schleifenstrom (i) bestimmt wird, indem er gemessen oder indem ein Sollstrom ausgelesen wird.

4. Verfahren nach einem der Ansprüche 1 bis 3, **dadurch gekennzeichnet, dass** die mindestens eine weitere Betriebsparameter-Zugehörigkeitsfunktion eine Zeitabstands-Zugehörigkeitsfunktion ist, welche einem Zeitabstand (Δt) einen Zeitabstands-Zugehörigkeitsgrad (Zₜ) zu einer Zeitabstands-Fuzzy-Menge von ausreichenden Zeitabständen zuweist,
dass von dem Messgerät (1) ab oder bis zu einem vor dem ersten Zeitpunkt (t₁) liegenden Ausführungszeitpunkt (t₂) ein Verfahrensschritt ausgeführt wird, insbesondere von der Stromschleifenschnittstelle (4) eine Kommunikation oder von der Messvorrichtung (6) eine Messung ausgeführt wird und dass von der Steuerung (5) ein Zeitabstand (Δt) zwischen dem ersten Zeitpunkt (t₁) und dem Ausführungszeitpunkt (t₂) als der Betriebsparameterwert bestimmt wird.

5. Verfahren nach einem der Ansprüche 1 bis 4, **dadurch gekennzeichnet, dass** die mindestens eine weitere Betriebsparameter-Zugehörigkeitsfunktion eine Spannungssteigungs-Zugehörigkeitsfunktion ist, welche einer Spannungssteigung (u/t) einen Spannungssteigungs-Zugehörigkeitsgrad (Zᵤₛ) zu einer Spannungssteigungs-Fuzzy-Menge von ausreichenden Spannungssteigungen zuweist und
dass von der Steuerung (5) eine zweite Pufferspannung (u₂) in einem zweiten Zeitpunkt (t₂) gemessen und eine Spannungssteigung (u/t) zwischen dem ersten Zeitpunkt (t₁) und dem zweiten Zeitpunkt (t₂) aus der ersten Pufferspannung (u₁) und der zweiten Pufferspannung (u₂) als der Betriebsparameterwert bestimmt wird.

6. Verfahren nach einem der Ansprüche 1 bis 5, **dadurch gekennzeichnet, dass** die mindestens eine weitere Betriebsparameter-Zugehörigkeitsfunktion eine Stromsteigungs-Zugehörigkeitsfunktion ist, welche einer Stromsteigung (i/t) einen Stromsteigungs-Zugehörigkeitsgrad (Zᵢₛ) zu einer Stromsteigungs-Fuzzy-Menge von ausreichenden Stromsteigungen zuweist und
dass von der Steuerung (5) ein erster Schleifenstrom im ersten Zeitpunkt und ein zweiter Schleifenstrom in einem zweiten Zeitpunkt bestimmt und eine Stromsteigung (i/t) zwischen dem ersten Zeitpunkt und dem zweiten Zeitpunkt aus dem ersten Schleifenstrom und aus dem zweiten Schleifenstrom als der Betriebsparameterwert bestimmt wird.

7. Verfahren nach Anspruch 6, **dadurch gekennzeichnet, dass** der erste Schleifenstrom und der zweite Schleifenstrom bestimmt werden, indem sie gemessen oder indem Sollströme ausgelesen werden.

8. Verfahren nach einem der Ansprüche 1 bis 7, **dadurch gekennzeichnet, dass** die Verknüpfung zumindest eine Multiplikation umfasst.

9. Verfahren nach einem der Ansprüche 1 bis 8, **dadurch gekennzeichnet, dass** von der Steuerung (5), wenn der Ergebnis-Zugehörigkeitsgrad (Zₑ) größer als ein erster Grenzwert ist, der weitere Verfahrensschritt eine von der Messvorrichtung (6) ausführbare Messung oder Diagnose oder ausführbarer Verbrauchsalgorithmus ist und dass, wenn der Ergebnis-Zugehörigkeitsgrad (Zₑ) kleiner als der erste Grenzwert und größer als ein zweiter Grenzwert ist, der weitere Verfahrensschritt eine von der Stromschleifenschnittstelle (4) ausführbare Kommunikation.

10. Verfahren nach einem der Ansprüche 1 bis 9, **dadurch gekennzeichnet, dass** von der Steuerung (5), wenn der Ergebnis-Zugehörigkeitsgrad (Zₑ) null ist, der weitere Verfahrensschritt ein Nullschritt ist.

11. Messgeräts (1) mit einer Versorgungsvorrichtung (2) mit einem Pufferspeicher (3) und als Verbraucher einer Stromschleifenschnittstelle (4), einer Steuerung (5) und einer Messvorrichtung (6),
wobei die Stromschleifenschnittstelle (4) zur Verbindung mit einer Stromschleife (7) und zur Kommunikation über die Stromschleife (7) ausgebildet ist,
wobei die Versorgungsvorrichtung (2) zur Versorgung mit Energie aus der Stromschleife (7) und zur Versorgung der Verbraucher mit Energie unter Verwendung des Pufferspeichers (3) ausgebildet ist,
**dadurch gekennzeichnet,**
**dass** in der Steuerung (5) eine Spannungs-Zugehörigkeitsfunktion abgespeichert ist, welche einer Pufferspannung (u) des Pufferspeichers (3) einen Spannungs-Zugehörigkeitsgrad (Zᵤ) zu einer Spannungs-Fuzzy-Menge von ausreichenden Pufferspannungen zuweist,
**dass** in der Steuerung (5) mindestens eine Betriebsparameter-Zugehörigkeitsfunktion abgespeichert ist, welche einem Betriebsparameterwert (i, Δt, u/t, i/t) des Messgeräts (1) einen Betriebsparameter-Zugehörigkeitsgrad (Zᵢ, Zₜ, Zᵤₛ, Zᵢₛ) zu einer Betriebsparameter-Fuzzy-Menge ausreichender Betriebsparameterwerte zuweist,
**dass** die Steuerung (5) ausgebildet ist, mindestens einen Betriebsparameterwert (i, Δt, u/t, i/t) zu bestimmen und in einem ersten Zeitpunkt (t₁) eine erste Pufferspannung (u₁) zu messen,
**dass** die Steuerung (5) zum Ausführen eines Fuzzy-Algorithmus mit den folgenden Verfahrensschritten ausgebildet ist:
- Bestimmen des Spannungs-Zugehörigkeitsgrads (Zᵤ) der ersten Pufferspannung (u₁) unter Verwendung der Spannungs-Zugehörigkeitsfunktion,
- Bestimmen des mindestens einen Betriebsparameter-Zugehörigkeitsgrads (Zᵢ, Zₜ, Zᵤₛ, Zᵢₛ) des mindestens einen Betriebsparameterwerts (i, Δt, u/t, i/t) unter Verwendung der mindestens einen Betriebsparameter-Zugehörigkeitsfunktion,
- Bestimmen eines Ergebnis-Zugehörigkeitsgrads (Zₑ) durch Verknüpfung des Spannungs-Zugehörigkeitsgrads (Zᵤ) und des mindestens einen Betriebsparameter-Zugehörigkeitsgrads (Zᵢ, Zₜ, Zᵤₛ, Zᵢₛ) miteinander und dass die Steuerung (5) ausgebildet ist, unter Verwendung des Ergebnis-Zugehörigkeitsgrads (Zₑ) einen weiteren vom Messgerät (1) ausführbaren Verfahrensschritt zu bestimmen, welcher nicht mehr als eine zur Verfügung stehende Energie für eine Dauer einer Ausführung des Verfahrensschritts benötigt.

12. Messgerät (1) nach Anspruch 11, **dadurch gekennzeichnet, dass** das Messgerät (1), insbesondere die Steuerung (5), ausgebildet ist, ein Verfahren nach einem der Ansprüche 2 bis 10 auszuführen.

13. Messgerät (1) nach Anspruch 11 oder 12, **dadurch gekennzeichnet, dass** die Stromschleifenschnittstelle (4) zur Kommunikation gemäß einem 4 mA bis 20 mA-Standard über die Stromschnittstelle (7) ausgebildet ist.

14. Messgerät (1) nach einem der Ansprüche 11 bis 13, **dadurch gekennzeichnet, dass** die Stromschleifenschnittstelle (4) zur Kommunikation gemäß einem digitalen Busprotokoll über die Stromschnittstelle (7), insbesondere einem HART-Standard, und/oder gemäß einem Bluetooth-Standard über einen zusätzlichen Transceiver in der Stromschleifenschnittstelle ausgebildet ist.

15. Messgerät (1) nach einem der Ansprüche 11 bis 14, **dadurch gekennzeichnet, dass** der Pufferspeicher (3) ein Kondensator ist.

16. Messgerät (1) nach einem der Ansprüche 1 bis 15, **dadurch gekennzeichnet, dass** das Messgerät (1) ein Füllstandsmessgerät, vorzugsweise ein Radar-Füllstandsmessgerät ist.
